# EUROPÄISCHE PATENTANMELDUNG

(11) **EP 4 335 951 A1**
(43) Veröffentlichungstag der Anmeldung: **13.03.2024**
(21) Anmeldenummer: 22194563.7
(22) Anmeldetag: 08.09.2022
(51) Int. Cl.: C30B 25/12, C23C 16/458, H01L 21/687

(54) **SUSZEPTOR MIT AUSTAUSCHBAREN AUFLAGEELEMENTEN**

(71) Anmelder: Siltronic AG, 81677 München (DE)
(72) Erfinder: VORDERWESTNER, Martin, 83567 Unterreit (DE); MOOS, Patrick, 84568 Pleiskirchen (DE)

(57) **Zusammenfassung**

Suszeptor für eine Vorrichtung zum Abscheiden einer Schicht aus Halbleitermaterial auf einer Substratscheibe (40) mittels Abscheidung aus der Gasphase, wobei der Suszeptor eine Suszeptorplatte und mindestens einen Substrathalter (5) für eine Substratscheibe (40) auf der Suszeptorplatte umfasst, der mindestens eine Substrathalter (5) ein kreisscheibenförmiges Unterteil (10) mit einer oberen Tragfläche, einen auf der oberen Tragfläche des Unterteils (10) aufliegenden Substratträgerring (20), und Auflageelemente (30) zur Randauflage der Substratscheibe (40) aufweist, und die Auflageelemente (30) konzentrisch um den Ringmittelpunkt des Substratträgerrings (20) herum angeordnet sind, dadurch gekennzeichnet, dass der Substratträgerring (20) Einstecköffnungen und die Auflageelemente (30) Einsteckabschnitte aufweisen, die Einsteckabschnitte austauschbar in zumindest einem Teil der Einstecköffnungen angeordnet sind, und die Auflageelemente eine radiale Breite von 5 mm oder weniger aufweisen;
Vorrichtung zum Abscheiden einer Schicht aus Halbleitermaterial auf einer Substratscheibe (40) mittels Abscheidung aus der Gasphase; und
ein Verfahren zur Abscheidung einer epitaktischen Schicht.

## Beschreibung

Gegenstand der Erfindung ist ein Suszeptor für eine Vorrichtung zum Abscheiden einer Schicht aus Halbleitermaterial auf einer Substratscheibe mittels Gasphasenabscheidung, eine Vorrichtung zum Abscheiden einer Schicht aus Halbleitermaterial auf einer Substratscheibe mittels Gasphasenabscheidung, die einen solchen Suszeptor umfasst, und ein Verfahren, im Zuge dessen die Vorrichtung verwendet wird.

Anspruchsvolle Anwendungen auf dem Gebiet der Herstellung von Grundmaterial für die elektronische Industrie umfassen die Abscheidung einer Schicht aus Halbleitermaterial auf einer Substratscheibe, insbesondere die chemische Gasphasenabscheidung (Chemical Vapor Deposition, CVD) einer epitaktischen Schicht aus Halbleitermaterial auf einer Substratscheibe. Dabei wird ein Prozessgas, das reaktive gasförmige Vorläuferverbindungen (Precursor) enthält, über die Substratscheibe geleitet, wobei durch chemische Reaktion der gasförmigen Vorläuferverbindungen an der Oberfläche der Substratscheibe eine kristalline Materialschicht epitaktisch auf der Substratscheibe abgeschieden wird.

Das Abscheiden der epitaktischen Schicht auf der Substratscheibe mittels CVD erfolgt üblicherweise in der Prozesskammer einer Abscheidevorrichtung, die eine Substratscheibe aufnehmen kann. Während des Abscheidens der epitaktischen Schicht liegt die Substratscheibe auf einem Suszeptor und wird durch eine Heizeinrichtung in der Prozesskammer auf die Abscheidetemperatur gebracht. Der Suszeptor besteht üblicherweise aus einer Suszeptorplatte und Auflageelementen, auf denen die Substratscheibe aufliegt.

Für die Abscheidung einer epitaktischen Schicht eines Halbleitermaterials auf einer Substratscheibe können Vorrichtungen, wie beispielsweise der in US 2009 314 205A1 beschriebene Einzelscheiben-Reaktor verwendet werden. Er verfügt über einen Grundring, der zwischen einer oberen und einer unteren Kuppel angeordnet ist. Sie formen zusammen einen Reaktionsraum, der einen Suszeptor beherbergt, der die Substratscheibe während des Abscheidens der Schicht aus Halbleitermaterial trägt. Die Substratscheibe wird durch eine Schlitzventil-Türe und einen Schlitzventil-Tunnel in den Reaktionsraum transportiert. Das Prozessgas wird durch Gaszuleitungen von einem Gaseinlass zu einem Gasauslass geleitet. Die Substratscheibe wird mittels Wärmestrahlung auf Abscheidetemperatur gebracht. Der prinzipielle Aufbau einer Vorrichtung zum Abscheiden einer von einem Prozessgas stammenden Materialschicht auf einer Substratscheibe geht beispielsweise auch aus der Beschreibung der WO 2007/050309 A1 hervor.

In modernen Planetenreaktoren, beispielsweise einem Reaktor des Typs AIX G5+ des Herstellers Aixtron, rotiert eine kreisscheibenförmige Suszeptorplatte, die mehrere als Satelliten bezeichnete Substrathalter trägt, um die eigene Achse. Zudem wird jede Substratscheibe zusammen mit den Satelliten durch einen Gasstrom in der Prozesskammer von der Suszeptorplatte angehoben und in Rotation versetzt, so dass eine relativ gleichmäßige Beschichtung der Substratscheiben erreicht wird. Die Mehrfachrotation der Substratträger stellt sicher, dass die Abscheidung mit verbesserter Homogenität bezüglich Schichtdicke, Zusammensetzung und Dotierung erfolgt.

Aus der DE 10 2012 106 796 A1 ist ein Suszeptor zur thermischen Behandlung eines Halbleitersubstrats bekannt, bei dem die Oberseite des Substratträgerrings Vorsprünge in Vertikalrichtung aufweist, auf denen das Substrat aufliegt.

Die DE 10 2017 129 699 A1 beschreibt eine Halterung zum Transport einer Substratscheibe, mit einem Ringkörper, der eine Ringöffnung umgibt. Der Ringkörper weist einen Innenabschnitt, einen Außenabschnitt und zumindest einen zwischen dem Innenabschnitt und dem Außenabschnitt angeordneten Zwischenabschnitt auf, wobei der Innenabschnitt mit einer Oberseite eine Auflagefläche zur Randauflage des Substrates ausbildet.

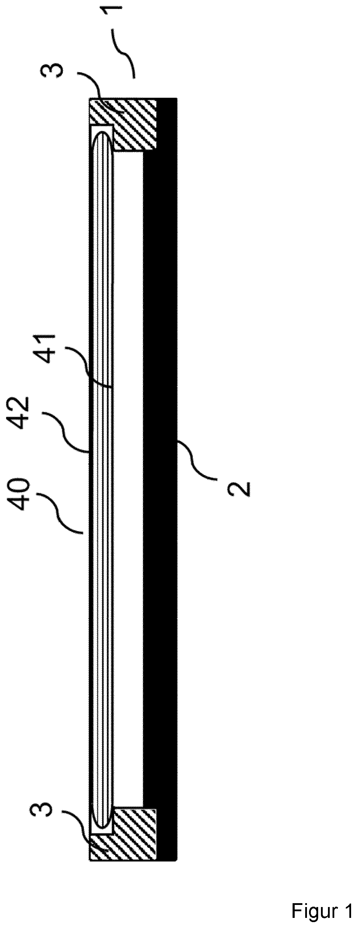

Ein typischer Substrathalter (1) mit einem kreisscheibenförmigen Unterteil (2) und einem Substratträgerring (3) zur Randauflage einer Substratscheibe (40) ist in der **Figur 1** dargestellt. Die Vorderseite (42) der Substratscheibe (40) ist diejenige Seitenfläche der Substratscheibe, auf der die epitaktische Schicht abgeschieden wird. Die Rückseite (41) ist die auf dem Substrathalter aufliegende Seitenfläche der Substratscheibe (40). Durch die Auflagefläche des Suszeptors wir ein Teil der Rückseite (41) der Substratscheibe (40) vom Gasstrom abgeschirmt. Außerdem bewirkt der direkte Kontakt zwischen der Auflagefläche des Suszeptors und der Rückseite der Substratscheibe eine unterschiedliche Wärmeleitung an der aufliegenden Fläche der Substratscheibe im Vergleich zur nicht aufliegenden Fläche. Dies hat zur Folge, dass sich die Temperatur an der Oberfläche der Substratscheibe sowohl an der Rückseite als auch an der Vorderseite zwischen aufliegender und nicht aufliegender Fläche örtlich unterscheidet. Die Oberflächentemperatur hat im CVD-Prozess großen Einfluss auf die Abscheiderate und die Struktur der epitaktischen Schicht.

Die nicht einheitliche Oberflächentemperatur der Substratscheibe während des Abscheideprozesses bewirkt daher, dass die Dicke der epitaktischen Schicht an der aufliegende Randfläche der Substratscheibe und der der Auflagefläche gegenüberliegende Fläche an der Vorderseite der Substratscheibe eine unterschiedliche Dicke im Vergleich zur nicht aufliegenden Fläche an Vorder- und Rückseite aufweist. Aufgrund der nicht einheitlichen Dicke der epitaktischen Schicht ist die am Suszeptor aufliegende Randfläche der beschichteten Substratscheibe nicht für moderne elektronische Bauteile nutzbar. Dieser Randausschluss muss deshalb verworfen werden. Unter Randausschluss ("edge exclusion") ist der radiale Abstand vom Rand der Substratscheibe, innerhalb dessen die vom Abnehmer spezifizierten Qualitätserfordernisse nicht erfüllt sind, zu verstehen.

Neben einer möglichst einheitlichen Oberflächentemperatur der Substratscheibe ist eine stabile Auflage der Substratscheibe eine weitere Anforderung an den Suszeptor. Eine stabile Auflage der Substratscheibe ist insbesondere erforderlich, um Rückseitendefekte wie beispielsweise Kratzer zu vermeiden, die bei einer Bewegung der Substratscheibe relativ zu den Auflageelementen entstehen. Gerade in modernen Planetenreaktoren ist aufgrund der während der Beschichtung erfolgenden Anhebung und Rotation der auch als Satelliten bezeichneten Substrathalter eine stabile Lagerung der Substratscheiben auf dem Substrathalter von großer Bedeutung. Außerdem kann eine Fehlanordnung der Substratscheibe bezüglich deren Lage relativ zur Lage des Suszeptors zu einem größeren Randausschluss führen und sich deshalb nachteilig auf die Ausbeute auswirken.

Der Verlauf der Oberflächentemperatur auf der Substratscheibe wird auch durch die Prozessbedingungen, insbesondere die Prozesstemperatur, die Wärmeleitfähigkeit des Prozessgases und die Strömungsverhältnisse in der Prozesskammer bestimmt. Eine Änderung der Prozessbedingungen kann somit zu einer Verringerung des Flächenanteils auf der Substratscheibe, auf dem die epitaktische Schicht gleichmäßig ausgebildet ist, führen. Außerdem kann unter bestimmten Prozessbedingungen, beispielsweise bei einer hohe Rotationsgeschwindigkeit der Substratscheibe, eine größere Auflagefläche zur stabilen Lagerung der Substratscheibe auf dem Substrathalter nötig sein.

Eine Anpassung der Suszeptors an verschiedene Prozessbedingungen ist jedoch mit großem Aufwand verbunden und somit unwirtschaftlich.

Aufgabe der vorliegenden Erfindung ist die Bereitstellung eines Suszeptors, der es ermöglicht, den Flächenanteil auf der Substratscheibe, auf dem die epitaktische Schicht gleichmäßig ausgebildet ist und die frei von mechanischen Defekten ist, bei unterschiedlichen Prozessbedingungen zu erhöhen und so den Randausschluss zu verringern. Insbesondere ist es Aufgabe der vorliegenden Erfindung, einen Suszeptor bereitzustellen, der eine stabile Auflage der Substratscheibe in einem Planetenreaktor zur CVD-Abscheidung ermöglicht, ein Verkratzen der Substratscheibe verhindert, eine gleichmäßige Abscheidung der epitaktischen Schicht über einen weiten Bereich der Substratscheibe ermöglicht, und der für Substratscheiben unterschiedlicher Dicken und für verschiedene Prozessbedingungen des Abscheidungsprozesses geeignet ist.

Gelöst wird die Aufgabe gemäß dem ersten Aspekt der vorliegenden Erfindung durch einen Suszeptor für eine Vorrichtung zum Abscheiden einer Schicht aus Halbleitermaterial auf einer Substratscheibe mittels Abscheidung aus der Gasphase, wobei
der Suszeptor eine Suszeptorplatte und mindestens einen Substrathalter (5) für eine Substratscheibe (40) auf der Suszeptorplatte umfasst,
der mindestens eine Substrathalter (5) ein kreisscheibenförmiges Unterteil (10) mit einer oberen Tragfläche, einen auf der oberen Tragfläche des Unterteils (10) aufliegenden Substratträgerring (20), und Auflageelemente (30) für die Randauflage der Substratscheibe (40) aufweist, und
die Auflageelemente (30) konzentrisch um den Ringmittelpunkt des Substratträgerrings (20) herum angeordnet sind,
dadurch gekennzeichnet, dass
der Substratträgerring (20) Einstecköffnungen und die Auflageelemente (30) Einsteckabschnitte aufweisen,
die Einsteckabschnitte austauschbar in zumindest einem Teil der Einstecköffnungen angeordnet sind, und
die Auflageelemente eine radiale Breite von 5 mm oder weniger aufweisen.

Gemäß dem zweiten Aspekt betrifft die Erfindung eine Vorrichtung zum Abscheiden einer Schicht aus Halbleitermaterial auf einer Substratscheibe mittels Abscheidung aus der Gasphase, wobei die Vorrichtung
ein Reaktorgehäuse,
eine Heizeinrichtung,
einen Gaseinlass und einen Gasauslass, eine Abgasleitung sowie Gaszuleitungen zum Leiten von Prozessgas über eine Seitenfläche der Substratscheibe (40);
einen Suszeptor gemäß dem ersten Aspekt der vorliegenden Erfindung,
und eine Hub- und Rotationseinrichtung zum Heben und Drehen des Suszeptors umfasst.

Schließlich ist die vorliegende Erfindung gemäß dem dritten Aspekt auf ein Verfahren zum Abscheiden einer epitaktischen Schicht aus Halbleitermaterial auf einer Substratscheibe (40) gerichtet, das dadurch gekennzeichnet, dass eine Substratscheibe (40) in der Vorrichtung gemäß dem zweiten Aspekt mit einer epitaktischen Schicht beschichtet wird.

Bevorzugte Ausführungsformen des ersten bis dritten Aspektes der vorliegenden Erfindung sind Gegenstand der abhängigen Ansprüche.

### Kurzbeschreibung der Figuren

**Figur 1** ist eine den Stand der Technik repräsentierende Abbildung eines Substratträgers (1), die die relative Anordnung eines kreisscheibenförmigen Unterteils (2), eines Substratträgerrings (3) und einer Substratscheibe (40) zeigt.
**Figur 2** zeigt einen Schnitt in radialer Richtung einer Ausführungsform eines Substrathalters (5) mit erfindungsgemäßen Merkmalen. Der Substrathalter (5) besteht aus einem kreisscheibenförmigen Unterteil (10) mit einem an der Außenseite umlaufenden, stufenförmigen Sims (11), einem auf dem Sims aufliegenden Substratträgerring (20) mit einer Stufe (21) auf der radialinwärtsliegenden Seite, und auf der Stufe (21) angebrachten Auflageelementen (30), deren Oberseite in einem radialinwärtsliegenden Bereich in Radialinwärtsrichtung abfällt.
**Figur 3** zeigt den Querschnitt einer Ausführungsform eines Substrathalters (5) mit erfindungsgemäßen Merkmalen. Die Auflageelemente (30) sind konzentrisch in gleichem Abstand auf der Bodenfläche der Stufe (21) an der Innenseite des Substratträgerrings (20) angeordnet.

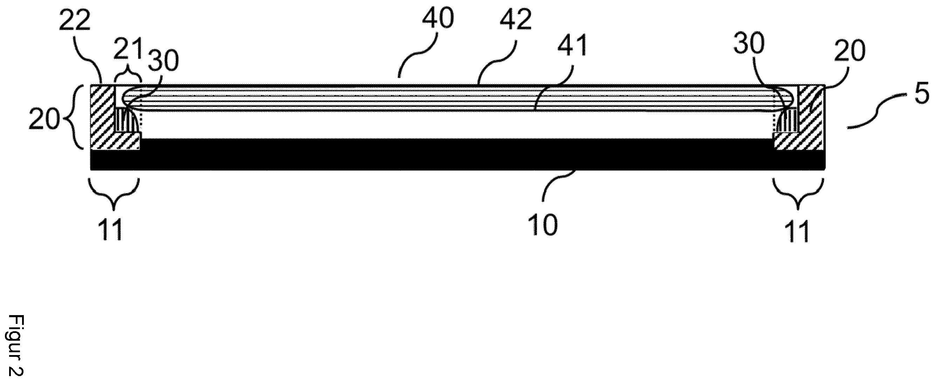

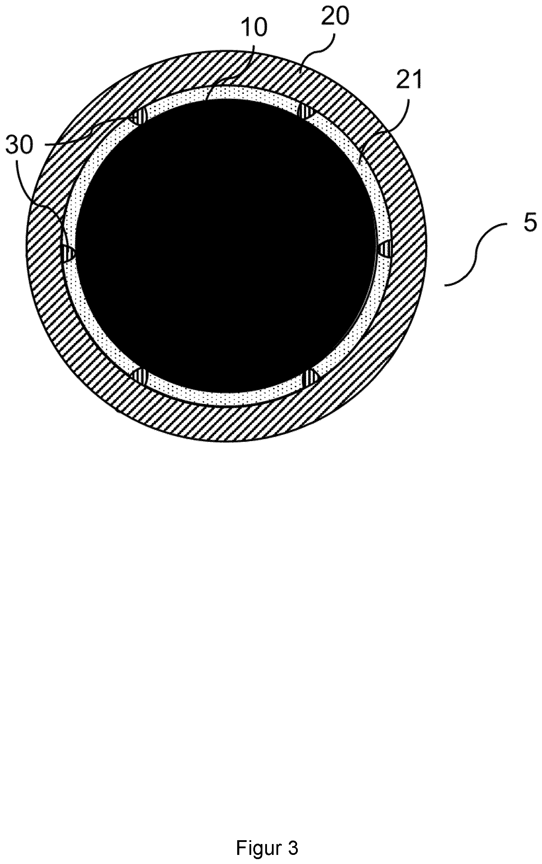

**Figur 2** und **3** zeigen dieselbe Ausführungsform aus unterschiedlichen Perspektiven.

### Detaillierte Beschreibung der Erfindung

Der erfindungsgemäße Suszeptor ist vorzugsweise für Substratscheiben (40) mit einem Durchmesser von 150 bis 300 mm, besonders bevorzugt 150 bis 200 mm, am meisten bevorzugt 200 mm, geeignet. Die Substratscheiben sind vorzugsweise Halbleiterscheiben aus einkristallinem Silizium, Germanium, Siliziumcarbid oder Galliumnitrid. Der Rand der Substratscheibe ist vorzugsweise abgerundet. Der abgerundete Rand der Substratscheibe ist definiert als der radiale, ringförmige Randbereich der Substratscheibe, in dem sich die Dicke der Substratscheibe in Radialauswärtsrichtung verringert oder verjüngt. Dabei ist unter der Dicke die axiale Ausdehnung der Substratscheibe senkrecht zur radialen Richtung zu verstehen.

Die Suszeptorplatte eines erfindungsgemäßen Suszeptors besteht vorzugsweise aus Graphit, Graphit-Filz, oder Siliziumcarbid oder aus einem mit Siliziumcarbid beschichteten Material. Das mit Siliziumcarbid beschichtete Material ist bevorzugt Graphit, Graphit-Filz, oder Silizium. Die Suszeptorplatte ist bevorzugt kreisscheibenförmig und hat einen größeren Durchmesser als die Substratscheibe (40). Vorzugsweise weist der Suszeptor ein Mittel zur Drehlagerung auf, so dass der Suszeptor um die eigene Achse rotieren kann.

Der erfindungsgemäße Suszeptor umfasst vorzugsweise mehrere Substrathalter (5), die konzentrisch um den Mittelpunkt der vorzugsweise kreisscheibenförmigen Suszeptorplatte angeordnet sind. In diesem Fall ist der Durchmesser der Suszeptorplatte vorzugsweise größer als der doppelte Durchmesser der Substratscheibe (40). Besonders bevorzugt ist ein Suszeptor mit fünf Substrathaltern (5) für Substratscheiben (40) mit einem Durchmesser von 200 mm und ein Suszeptor mit acht Substrathaltern (5) für Substratscheiben (40) mit einem Durchmesser von 150 mm, wobei die fünf beziehungsweise acht Substrathalter (5) konzentrisch um den Mittelpunkt der kreisscheibenförmigen Suszeptorplatte angeordnet sind.

Der mindestens eine Substrathalter (5) umfasst ein kreisscheibenförmiges Unterteil (10) mit einer oberen Tragfläche, einen auf der oberen Tragfläche des Unterteils (10) aufliegenden Substratträgerring (20), und Auflageelemente (30) für die Randauflage der Substratscheibe (40). Das kreisscheibenförmige Unterteil (10), der Substratträgerring (20), und die Auflageelemente (30) bestehen jeweils vorzugsweise aus Siliziumcarbid oder aus einem anderen Material, das mit Siliziumcarbid beschichtet ist, wobei das andere Material vorzugsweise Graphit oder Silizium ist.

In einer besonders bevorzugten Ausführungsform weisen sowohl die Suszeptorplatte als auch das kreisscheibenförmige Unterteil (10) eines jeden Substrathalters (5) ein Mittel zur Drehlagerung auf, so dass die Substratscheiben (40) während des Abscheideverfahrens um den Mittelpunkt der Substratplatte und um die eigene Achse rotieren können.

Der Substratträgerring (20) hat einen Innendurchmesser und einen Außendurchmesser. Die radiale Breite an der Unterseite des Substratträgerrings (20) entspricht der Hälfte der Differenz von Außendurchmesser und Innendurchmesser an der Unterseite des Substratträgerrings (20). In einer Ausführungsform ist der Innendurchmesser an der Unterseite kleiner und der Außendurchmesser an der Unterseite des Substratträgerrings (20) größer als der Durchmesser der Substratscheibe (40), auf deren Vorderseite eine epitaktische Schicht abgeschieden werden soll.

Das kreisscheibenförmige Unterteil (10) hat bevorzugt einen an der Außenseite umlaufenden, stufenförmigen Sims (11), auf dem der Substratträgerring (20) aufliegt. Der Sims (11) erstreckt sich vom äußeren Rand des kreisscheibenförmigen Unterteils (10) bis zu einer weiter radialinwärtsliegenden umlaufenden Wand, die eine Stufe ausbildet und den innenliegenden, höheren, und ebenfalls kreisscheibenförmigen oberen Teil des kreisscheibenförmigen Unterteils abgrenzt. Der Durchmesser des oberen Teils des kreisscheibenförmigen Unterteils (10) mit dem an der Außenseite umlaufenden, stufenförmigen Sims (11) entspricht dabei dem Innendurchmesser an der Unterseite des Substratträgerrings (20), so dass der Substratträgerring (20) auf das kreisscheibenförmige Unterteil (10) gesteckt werden kann. Die radiale Breite des umlaufenden, stufenförmigen Sims (11) des kreisscheibenförmigen Unterteils (10) entspricht dabei vorzugsweise der radialen Breite an der Unterseite des Substratträgerrings (20).

Der Substratträgerring (20) weist vorzugsweise an seiner radialinwärtsliegenden Seite eine Stufe (21) mit einer nach oben weisenden ringförmigen Bodenfläche parallel zur Ringebene und einer Wandfläche senkrecht zur Ringebene auf. Die Wandfläche senkrecht zur Ringebene grenzt dabei die Stufe von der Oberfläche (22) am äußeren, oberen Rand des Substratträgerrings ab. Die Einstecköffnungen des Substratträgerrings (20) sind vorzugsweise in die Bodenfläche und/oder die Wandfläche der Stufe (21) eingebracht, besonders bevorzugt in die Bodenfläche. Die Substratscheibe (40) liegt dabei bevorzugt so auf den Auflageelementen (30) auf, dass die Substratscheibe (40) nicht die Wandfläche des Substratträgerrings (20) senkrecht zur Ringebene berührt. Dementsprechend ist der Durchmesser des durch die Wandfläche der Stufe gebildeten Kreises größer als der Durchmesser der Substratscheibe, vorzugsweise 2 bis 40 mm, mehr bevorzugt 5 bis 30 mm, und am meisten bevorzugt 10 bis 20 mm größer als der Durchmesser der Substratscheibe.

Der Substratträgerring und die Auflageelemente eines erfindungsgemäßen Suszeptors bestehen vorzugsweise aus Graphit, Graphit-Filz, oder Siliziumcarbid oder aus einem mit Siliziumcarbid beschichteten Material. Das mit Siliziumcarbid beschichtete Material ist bevorzugt Graphit, Graphit-Filz, oder Silizium. Der Substratträgerring und die Auflageelemente könne aus demselben oder verschiedenen Materialien bestehen.

Wie in **Figur 2** dargestellt, liegt die Substratscheibe (40) bevorzugt so auf den Auflageelementen (30) auf, dass die Oberfläche an der Vorderseite (Oberseite, 42) der Substratscheibe (40) in einer Ebene mit der Oberfläche an der Oberseite (22) des Substratträgerrings (20) liegt. Wenn die Oberfläche an der Vorderseite (42) der Substratscheibe (40) höher oder tiefer als die Oberfläche (22) am äußeren, oberen Rand des Substratträgerrings (20) liegt, kann es zum Strömungsabriss von der Oberfläche (42) der Substratscheibe (40) und somit zu einer ungleichmäßigen Beschichtung der Substratscheibe kommen. Dies führt dazu, dass Suszeptoren aus dem Stand der Technik nur für Substratscheiben einer bestimmten Dicke geeignet sind. Es müssen also unterschiedliche Suszeptoren für die Beschichtung von Substratscheiben unterschiedlicher Dicke verwendet werden, um optimale Strömungsverhältnisse und damit eine gleichmäßigere Beschichtung zu gewährleisten, was zusätzliche Kosten verursacht.

Die Auflageelemente (30) des erfindungsgemäßen Suszeptors sind austauschbar ausgestaltet. Durch die Verwendung austauschbarer Auflageelemente (30) unterschiedlicher Höhe kann die Höhe der Auflagefläche und deren Form variiert und somit auf die Dicke der Substratscheibe (40) und außerdem auf die Geometrie des abgerundeten Rands der Substratscheibe so eingestellt werden, dass die Vorderseite (42) der Substratscheibe (40) in einer Ebene mit der Oberseite (22) des Substratträgerrings (20) liegt. Somit kann der Suszeptor einfach und kostengünstig an die Dicke der Substratscheibe (40) und die Geometrie des abgerundeten Rands der Substratscheibe (40) angepasst werden. Dies ermöglicht optimale Strömungsverhältnisse und dadurch eine gleichmäßigere Beschichtung unterschiedlicher Substratscheiben, ohne dass ein Austausch des gesamten Suszeptors oder des gesamten Substrathalters erforderlich ist. Zudem kann durch die Verwendung austauschbarer Auflageelemente (30) unterschiedlicher Höhe auch der Abstand der Unterseite (41) der Substratscheibe (40) zum Unterteil (10) und damit die Wärmezufuhr zur Substratscheibe (40) variiert werden. Dies ermöglicht es, die Prozessführung zu verändern, ohne dass ein Austausch des gesamten Suszeptors oder des gesamten Substrathalters erforderlich ist.

Die Auflageelemente (30) des Substrathalters (5) sind austauschbar ausgestaltet. Die Einsteckabschnitte der Auflageelemente (30) sind in den Einstecköffnungen des Substratträgerrings (20) austauschbar befestigt. Wie in **Figur 3** dargestellt, sind die Auflageelemente (30) konzentrisch um den Ringmittelpunkt des Substratträgerrings (20) herum angeordnet. Die Auflageelemente (30) sind dabei bevorzugt so ausgestaltet, dass ihre Oberseite eine Auflagefläche mit einer radialen Breite von 5 mm oder weniger, besonders bevorzugt 3 mm oder weniger, und am meisten bevorzugt 1 mm oder weniger zur Randauflage der Substratscheibe (40) aufweist. In der in der **Figur 3** dargestellten Ausführungsform eines Substrathalters (5) sind dabei die Auflageelemente (30) auf der Stufe (21) des Substratträgerrings (20), der auf einem kreisscheibenförmigen Unterteil (10) angeordnet ist, austauschbar befestigt.

Die Auflageelemente haben vorzugsweise eine radiale Breite von 5 mm oder weniger, besonders bevorzugt 3 mm oder weniger und am meisten bevorzugt 1 mm oder weniger. Die radiale Breite der Auflageelemente ist vorzugsweise 0.5 mm oder mehr. Die radiale Breite der Auflageelemente ist ihre maximale Länge in radialer Richtung parallel zur Ringebene und wird bestimmt, wenn die Auflageelemente am Substratträgerring befestigt und ausgerichtet sind. Die Auflagefläche der Auflageelemente (30) fällt vorzugsweise in Radialinwärtsrichtung ab und ist besonders bevorzugt abgeschrägt oder gekrümmt.

Die Erfinder haben überraschend festgestellt, dass bei einer radialen Breite der Auflageelemente von 0.5 bis 5 mm, bevorzugt 0.5 bis 2 mm, besonders bevorzugt 0.5 bis 1 mm, die Fläche zur Randauflage und damit der Randausschluss der Substratscheibe verringert werden kann und gleichzeitig eine stabile Lagerung der Substratscheibe während des Abscheideverfahrens in einem Planetenreaktor gewährleistet ist. Gerade in Planetenreaktoren für CVD-Verfahren sind aufgrund der Mehrfachrotation der Substratscheiben, einerseits um die Achse des Suszeptors und andererseits um die Achse des jeweiligen Substrathalters (5), hohe Anforderungen an eine stabile Lagerung der Substrathalter (5) zu stellen, um eine gleichmäßige Beschichtung zu gewährleisten und mechanische Defekte auf der Rückseite zu vermeiden. Somit kann einerseits durch eine Verringerung der radialen Breite der Auflageelemente auf 0.5 bis 5 mm der Randausschluss reduziert und andererseits eine effiziente Verfahrensdurchführung des Abscheideverfahrens in einem Planetenreaktor beibehalten werden. Dies führt zu einer erheblichen Steigerung der gesamten nutzbaren Epitaxiefläche pro Produktionslauf im Vergleich zu bestehenden Systemen.

Die Auflageelemente (30) weisen besonders bevorzugt einen radialinwärtsliegenden Bereich und einen an den radialinwärtsliegenden Bereich angrenzenden radialauswärtsliegenden Bereich auf. Die Fläche an der Oberseite des radialauswärtsliegenden Bereichs bildet vorzugsweise eine Ebene parallel zur Ringebene des Substratträgerrings (20) aus. Diese Fläche an der Oberseite des radialauswärtsliegenden Bereichs weist vorzugsweise eine radiale Breite von 5 mm oder weniger auf und kann als Auflagefläche zur Randauflage der Substratscheibe (40) dienen.

Die Fläche an der Oberseite des radialinwärtsliegenden Bereichs der Auflageelemente (30) fällt vorzugsweise in Radialinwärtsrichtung ab. In einer besonders bevorzugten Ausführungsform ist die Oberseite des radialinwärtsliegenden Bereichs in Radialinwärtsrichtung gekrümmt oder abgeschrägt. Die Oberfläche an der Oberseite der Auflageelemente kann auch entlang ihrer gesamten radialen Breite in Radialinwärtsrichtung abfallen. Wenn die Oberfläche an der Oberseite der Auflageelemente entlang ihrer gesamten radialen Breite in Radialinwärtsrichtung abfällt, ist sie vorzugsweise gekrümmt.

Die Substratscheibe liegt vorzugsweise nur mit ihrem abgerundeten Randbereich auf den Auflageelementen (30) auf. In einer besonders bevorzugten Ausführungsform liegt die Substratscheibe nur auf dem Teil der Oberfläche der Auflageelemente auf, die in Radialinwärtsrichtung abfällt. Beispielsweise liegt die Substratscheibe dann nur auf dem radialinwärtsliegenden Bereich der Substratscheibe auf. Vorzugsweise berührt der Randbereich der Substratscheibe den Substratträgerring (20) nicht. Der Abstand in radialer Richtung zwischen dem Rand der Substratscheibe und der Innenwand des Substratträgerrings (20), vorzugsweise 2 bis 40 mm, ermöglicht eine radiale Ausdehnung der Substratscheibe während des Beschichtens.

Die Auflage auf dem in Radialinwärtsrichtung abfallenden Bereich der Oberfläche an der Oberseite der Auflageelemente (30) ermöglicht dabei, dass die Substratscheibe, in Folge einer thermischen Ausdehnung, über den in Radialinwärtsrichtung abfallenden Bereich der Auflageelemente (30) in Radialauswärtsrichtung gleiten kann, so dass die thermischen Spannungen in der Substratscheibe verringert werden können. Dies ermöglicht den Abbau der während des Beschichtens entstandenen thermischen Spannungen durch radiale Ausdehnung der Substratscheibe, ohne dass bei der Ausdehnung durch das Gleiten über die Auflageelemente (30) Rückseitendefekte entstehen.

Es wurde überraschend festgestellt, dass durch die Ausgestaltung der Auflageelemente (30) mit einer in Radialinwärtsrichtung abfallenden Oberfläche an der Oberseite der Auflageelemente die Beschädigung der Substratscheiben durch Zerkratzen während der Auflage auf dem Substratträgerring, während des Beschichtungsprozesses und während der Entnahme vom Substratträgerring (20) verhindert werden kann. Gleichzeitig beeinflusst die Ausgestaltung der Oberfläche die Strömungsverhältnisse in der Prozesskammer und damit über die Wärmeab- und zufuhr auch die Temperatur auf der Oberfläche der Vorder- und Rückseite der Substratscheibe. So führt die abfallende Oberfläche der Auflageelemente überraschenderweise auch zu einer Vergrößerung der nutzbaren Fläche mit einer gleichmäßig abgeschiedenen epitaktischen Schicht, insbesondere wenn die abfallende Oberfläche in Radialinwärtsrichtung gekrümmt oder abgeschrägt ist.

In einer Ausführungsform sind die Auflageelemente im radialinwärtsliegenden Bereich, oder auch die gesamte Oberfläche an der Oberseite der Auflageelemente, auch in tangentialer Richtung abgeschrägt oder gekrümmt.

Die Auflageelemente (30) sind vorzugsweise konzentrisch in gleichem Abstand entlang des Substratträgerrings (20) angeordnet. In einer bevorzugten Ausführungsform, wie in **Figur 3** dargestellt, sind sechs austauschbare Auflageelemente (30) am Substratträgerring (20) angebracht. Wenn die Einstecköffnungen in die Bodenfläche der Stufe (21) an der radialinwärtsliegenden Seite des Substratträgerrings (20) eingebracht sind, sind die der Einsteckabschnitte auf der Unterseite der Auflageelemente (30) angebracht.

Die Einstecköffnungen besitzen Bodenflächen, die vorzugsweise parallel zur Fläche des Trägerrings, in die sie eingebracht sind, angeordnet sind. Die Seitenflächen der Einstecköffnungen verlaufen im Wesentlichen senkrecht zur Bodenfläche. Die Einstecköffnungen, und entsprechend die Einsteckabschnitte, könne sich auch verjüngen. Der Grundriss der Bodenflächen der Einstecköffnungen ist vorzugsweise dreieckig, viereckig oder kreisförmig. Die Einsteckabschnitte der Auflageelementen (30) haben vorzugsweise denselben Grundriss wie die Einstecköffnungen. Die Oberfläche eines Auflageelements, wenn es über den Einsteckabschnitt in eine Einstecköffnung an den Substratträgerring angebracht ist, ist in axialer Blickrichtung, also senkrecht zur Ringebene betrachtet, vorzugsweise, rund, oval, hat die Form eines Kreissegmentes oder eines Kreissektors.

Gemäß dem zweiten Aspekt betrifft die Erfindung eine Vorrichtung zum Abscheiden einer Schicht aus Halbleitermaterial auf einer Substratscheibe (40) mittels Abscheidung aus der Gasphase, wobei die Vorrichtung
ein Reaktorgehäuse,
eine Heizeinrichtung,
einen Gaseinlass und einen Gasauslass, eine Abgasleitung sowie Gaszuleitungen zum Leiten von Prozessgas über eine Seitenfläche (42) der Substratscheibe (40);
einen Suszeptor gemäß dem ersten Aspekt, und
eine Hub- und Rotationseinrichtung zum Heben und Drehen des Suszeptors umfasst.

Das Reaktorgehäuse ist vorzugsweise ein CVD-Reaktor, der zum Beschichten von Substratscheiben mit einer epitaktischen Schicht unter Normaldruck oder Niederdruck (reduced pressure system) geeignet ist.

Die Heizeinrichtung ist vorzugsweise eine Strahlungsheizung, besonders bevorzugt eine induktiv beheizte Strahlungsquelle.

Der Gaseinlas ist vorzugsweise in der Mitte des Reaktordeckels angeordnet, so dass die für den Beschichtungsprozess erforderlichen Gase durch einen speziellen Gaseinlass von oben in die Mitte der Prozesskammer eingebracht werden.

Die Hub- und Rotationseinrichtung zum Heben und Drehen des Suszeptors umfasst bevorzugt einen Gaseinlass, beispielsweise ein Düse, aus dem Gas an die Unterseite (41) der Substratscheiben geleitet wird, so dass diese in Rotation versetzt und angehoben werden.

Die Vorrichtung ist bevorzugt ein Planetenreaktor, so dass der Suszeptor gemäß dem ersten Aspekt vorzugsweise mehrere Substrathalter (5) trägt, wobei die Suszeptorplatte und die kreisscheibenförmigen Unterteile (10) der Substrathalter (5) jeweils in der Mitte ein Mittel zur Drehlagerung aufweisen.

Gemäß dem dritten Aspekt ist die vorliegende Erfindung auf ein Verfahren zum Abscheiden einer epitaktischen Schicht aus Halbleitermaterial auf einer Substratscheibe gerichtet, das dadurch gekennzeichnet, dass eine Substratscheibe in der Vorrichtung gemäß dem zweiten Aspekt mit einer epitaktischen Schicht beschichtet wird.

Die Substratscheibe (40) ist vorzugsweise eine Halbleiterscheibe aus einkristallinem Silizium, Germanium, Siliziumcarbid oder Galliumnitrid. Die Substratscheibe hat vorzugsweise einen Durchmesser von 150 bis 300 mm, besonders bevorzugt von 150 bis 200 mm, am meisten bevorzugt 200 mm. Die Vorderseite der Substratscheibe ist vorzugsweise <100>-orientiert oder <110>-orientiert.

Das auf der Substratscheibe abgeschiedene Halbleitermaterial ist vorzugsweise Silizium, Germanium, eine Legierung dieser Elemente, oder ein III/V-Halbleitermaterial, besonders bevorzugt Galliumnitrid. Das Halbleitermaterial ist bevorzugt eine unter Normaldruck oder Niederdruck epitaktisch abgeschiedene Schicht aus einkristallinem Silizium oder einkristallinem Galliumnitrid. Die Substratscheibe und/oder die epitaktische Schicht können mit einem elektrisch aktiven Dotierstoff dotiert sein. Der Dotierstoff-Typ (p-Typ, n-Typ) kann gleich oder unterschiedlich sein.

Die Abscheidetemperatur für die Abscheidung einer Schicht aus einkristallinem Silizium beträgt vorzugsweise 900 bis 1300 °C, besonders bevorzugt 1080 bis 1150 °C. Die Abscheidetemperatur für die Abscheidung einer Schicht aus einkristallinem Galliumnitrid beträgt vorzugsweise 100 bis 1000 °C, besonders bevorzugt 600 bis 900°C und am meisten bevorzugt 700 bis 850 °C.

Das Prozessgas zur Abscheidung einer siliziumhaltigen Schicht aus Halbleitermaterial aus der Gasphase umfasst ein Chlorsilan und Wasserstoff und kann optional ein Dotierungsgas enthalten. Das Chlorsilan ist mindestens eine Verbindung ausgewählt aus der Gruppe aus Monochlorsilan, Dichlorsilan, Trichlorsilan und Tetrachlorsilan.

Das Prozessgas zur Abscheidung einer Galliumnitrid-Schicht umfasst eine Gallium-Verbindung und eine Stickstoffverbindung und kann optional ein Dotierungsgas enthalten. Die Gallium-Verbindung ist vorzugsweise eine Tiralkylgallium-Verbindung oder eine Trihalogengallium-Verbindung, vorzugsweise Trimethylgallium, Triethylgallium oder Trichlorgallium.

Die Stickstoff-Verbindung ist vorzugsweise Ammoniak. Das Dotierungsgas umfasst mindestens eine Verbindung ausgewählt aus kohlestoffhaltigen Verbindungen, eisenhaltigen Verbindungen, Diboran (B₂H₆), Monophosphan (PH₃) und Monoarsan (AsH₃).

In einer besonders bevorzugten Ausführungsform wird auf einer Substratscheibe aus monokristallinem Silizium mit einem Durchmesser von 200 mm unter Normaldruck oder Niederdruck eine epitaktische Schicht aus Galliumnitrid abgeschieden. Dabei wird ein Prozessgas, das eine Gallium-Verbindung, eine Stickstoffverbindung und optional ein Dotierungsgas umfasst, verwendet und bei 600 bis 1000°C eine epitaktische Schicht aus Galliumnitrid abgeschieden. Die Galliumverbindung ist bevorzugt Trimethly- oder Triethylgallium und die Stickstoffverbindung ist bevorzugt Ammoniak.

Während des Beschichtens rotieren die Substratscheiben sowohl um die eigene Achse als auch um den Mittelpunkt der Suszeptorplatte.

Während des Abscheidens einer Schicht aus Halbleitermaterial auf einer Substratscheibe wird vorzugswiese ein Spülgas eingesetzt, wobei das Verhältnis zwischen dem Druck des Prozessgases und dem Druck des Spülgases nicht kleiner als 0,1 und nicht größer als 1. Das Spülgas ist vorzugsweise Wasserstoff oder ein Wasserstoff enthaltendes Gas, beispielsweise ein Gemisch von HCI und Wasserstoff. Es können im mehreren aufeinanderfolgenden Schritten mehrere gleichartige oder verschiedene epitaktische Schichten auf der Substratscheibe abgeschieden werden.

### Ausführungsbeispiele

Auf Substratscheiben aus einkristallinem Silizium mit einem Durchmesser von 200 mm wurden in einer Vorrichtung vom Typ AIX G5+ des Herstellers Aixtron eine epitaktische Schicht aus einkristallinem Galliumnitrid abgeschieden. Es wurde ein Suszeptor mit fünf Substrathaltern für 200 mm Substratscheiben verwendet. Dabei wurden Substratträgerringe mit einer radialinwärts umlaufenden Stufe verwendet, auf der sechs in Radialinwärtsrichtung gekrümmte, austauschbare Auflageelemente angebracht wurden. Die Auflageelemente wiesen dabei eine radiale Breite von 1 mm auf und waren als Stifte (Pins) ausgestaltet. Nach dem Abscheideprozess wurden die Substratscheiben entnommen.

Die Scheiben wurden auf mechanische Defekte an der Rückseite untersucht und die Dicke der epitaktischen Schicht wurde bestimmt. Die Dicke der epitaktischen Schicht wich lediglich in einem Abschnitt am äußeren Rand der Scheibe mit einer radialen Breite von 1 mm von der gewünschten Spezifikation ab. Es wurden keine mechanischen Defekte (Kratzer) auf der Rückseite der Substratscheibe festgestellt. Dies zeigt, dass während des Abscheideverfahrens keine Relativbewegung der Substratscheibe zu den Auflageelemente stattgefunden hat und außerdem eine einheitliche Oberflächentemperatur in einem Bereich der mehr als einen 1 mm vom Scheibenrand entfernt war erreicht wurde.

Hingegen wurde in einem Vergleichsversuch bei ansonsten gleicher Verfahrensdurchführung ein konventioneller Substrathalter mit sechs Stiften mit einem Durchmesser von ca. 2 mm als Auflageelemente verwendet. Die ebenen Auflageflächen der Auflageelemente waren nicht abgeschrägt oder abgerundet. Die sechs nicht austauschbaren Stifte wurden dabei konzentrisch so auf dem kreisscheibenförmigen Unterteil des Substrathalters angeordnet, dass die Substratscheibe mit einem Durchmesser von 200 mm in einem radialen Abstand von mehr als 5 mm vom Scheibenrand auf den Mittelpunkten der Stifte auflag.

Nach der Beschichtung wurden auf den Substratscheibe Kratzer auf der Rückseite und eine ungleichmäßige epitaktischen Schicht in einem Randbereich mit einer radialen Breite von 8 mm beobachtet. Es wird angenommen, dass die Kratzer auf eine Relativbewegung der Substratscheibe in Bezug auf die Auflagestifte zurückzuführen sind.

Damit wurde für den erfindungsgemäßen Suszeptor einer Erhöhung der nutzbaren Fläche der epitaktisch beschichteten Substratscheibe im Vergleich zu einem konventionellen Suszeptor um 15% gezeigt.

## Patentansprüche

1. Suszeptor für eine Vorrichtung zum Abscheiden einer Schicht aus Halbleitermaterial auf einer Substratscheibe (40) mittels Abscheidung aus der Gasphase, wobei
der Suszeptor eine Suszeptorplatte und mindestens einen Substrathalter (5) für eine Substratscheibe (40) auf der Suszeptorplatte umfasst,
der mindestens eine Substrathalter (5) ein kreisscheibenförmiges Unterteil (10) mit einer oberen Tragfläche, einen auf der oberen Tragfläche des Unterteils (10) aufliegenden Substratträgerring (20), und Auflageelemente (30) zur Randauflage der Substratscheibe (40) aufweist, und
die Auflageelemente (30) konzentrisch um den Ringmittelpunkt des Substratträgerrings (20) herum angeordnet sind,
**dadurch gekennzeichnet, dass**
der Substratträgerring (20) Einstecköffnungen und die Auflageelemente (30) Einsteckabschnitte aufweisen,
die Einsteckabschnitte austauschbar in zumindest einem Teil der Einstecköffnungen angeordnet sind, und
die Auflageelemente eine radiale Breite von 5 mm oder weniger aufweisen.

2. Suszeptor gemäß dem Anspruch 1, wobei
die Auflageelemente (30) einen radialinwärtsliegenden Bereich und einen an den radialinwärtsliegenden Bereich angrenzenden radialauswärtsliegenden Bereich aufweisen,
die Fläche an der Oberseite des radialauswärtsliegenden Bereichs eine Ebene parallel zur Ringebene ausbildet, und
die Fläche an der Oberseite des radialinwärtsliegenden Bereichs in Radialinwärtsrichtung abfällt.

3. Suszeptor gemäß dem Anspruch 1 oder 2, wobei der Substratträgerring (20) an seiner radialinwärtsliegenden Seite eine Stufe (21) mit einer nach oben weisenden ringförmigen Bodenfläche parallel zur Ringebene und einer Wandfläche senkrecht zur Ringebene aufweist, und die Einstecköffnungen in die Bodenfläche und/oder die Wandfläche der Stufe (21) eingebracht sind.

4. Suszeptor gemäß dem Anspruch 2 oder 3, wobei die Fläche an der Oberseite des radialinwärtsliegenden Bereichs der Auflageelemente (30) in radialer Richtung gekrümmt ist.

5. Suszeptor gemäß dem Anspruch 2 oder 3, wobei die Fläche an der Oberseite des radialinwärtsliegenden Bereichs der Auflageelemente (30) in radialer Richtung abgeschrägt ist.

6. Suszeptor gemäß einem der Ansprüche 1 bis 5, wobei die Auflageelemente eine radiale Breite von 3 mm oder weniger aufweisen.

7. Suszeptor gemäß einem der Ansprüche 1 bis 6, wobei die Auflageelemente eine radiale Breite von 1 mm oder weniger aufweisen.

8. Suszeptor gemäß einem der Ansprüche 1 bis 7, wobei die Substratscheibe (40) einen Durchmesser von 150 bis 300 mm aufweist.

9. Suszeptor gemäß einem der Ansprüche 1 bis 8, wobei der Suszeptor 3 bis 8 Substrathalter (5) umfasst, die konzentrisch auf der Suszeptorplatte angeordnet sind.

10. Suszeptor gemäß dem Anspruch 9, wobei die Suszeptorplatte und die kreisscheibenförmigen Unterteile (10) der Substrathalter (5) jeweils in der Mitte ein Mittel zur Drehlagerung aufweisen.

11. Vorrichtung zum Abscheiden einer Schicht aus Halbleitermaterial auf einer Substratscheibe (40) mittels Abscheidung aus der Gasphase, umfassend
ein Reaktorgehäuse,
eine Heizeinrichtung,
einen Gaseinlass und einen Gasauslass, eine Abgasleitung sowie Gaszuleitungen zum Leiten von Prozessgas über eine Seitenfläche (42) der Substratscheibe (40);
einen Suszeptor gemäß einem der Ansprüche 1 bis 10, und
eine Hub- und Rotationseinrichtung zum Heben und Drehen des Suszeptors.

12. Verfahren zum Abscheiden einer epitaktischen Schicht aus Halbleitermaterial auf einer Substratscheibe (40), **dadurch gekennzeichnet, dass** eine Substratscheibe (40) in der Vorrichtung gemäß dem Anspruch 11 mit einer epitaktischen Schicht beschichtet wird.

13. Verfahren gemäß dem Anspruch 12, wobei die Substratscheibe (40) aus, optional dotierten, Silizium besteht und einen Durchmesser von 150 bis 300 mm aufweist.

14. Verfahren gemäß dem Anspruch 12 oder 13, wobei das Prozessgas eine Gallium-Verbindung, eine Stickstoffverbindung und optional ein Dotierungsgas umfasst.

15. Verfahren gemäß einem der Ansprüche 12 bis 14, wobei die Temperatur der Substratscheibe (40) während der Beschichtung 600 bis 1000 °C ist.
